# EUROPEAN PATENT SPECIFICATION

(11) **EP 2 013 924 B1**
(45) Date of publication and mention of the grant of the patent: **09.09.2009**
(21) Application number: 07747380.9
(22) Date of filing: 16.04.2007
(51) Int. Cl.: H01L 41/053, H03K 17/96

(54) **PIEZOELECTRIC MODULE FOR A SWITCH, INTEGRATED IN A HOUSING**
GEHÄUSEINTEGRIERTES PIEZOELEKTRISCHES MODUL FÜR EINEN SCHALTER
MODULE PIEZOELECTRIQUE POUR COMMUTATEUR INTEGRE DANS UN BOITIER

(30) Priority: 19.04.2006 NL 2000056
(43) Date of publication of application: 14.01.2009
(73) Proprietor: D-Switch B.V., 1521 NE Wormerveer (NL)
(72) Inventor: DE VRIES, René, Marcel, 1506 JE Zaandam (NL); FALLAST, Mario, 8044 Graz (AT)
(74) Representative: Eveleens Maarse, Pieter
(86) International application number: PCT/NL2007/050156
(87) International publication number: WO 2007/120042

(56) References cited:
- EP-A- 1 191 610
- JP-A- 9 166 616
- JP-A- 2003 198 313

## Description

The invention relates to a module for a piezoelectric switch, comprising a substantially flat piezoelectric element that is arranged for emitting an electrical signal on mechanical deformation, electrical connecting means for electrically connecting the piezoelectric element, positioning means for positioning the piezoelectric element and activating means for deforming the piezoelectric element. A piezoelectric element in this respect is understood to be an assembly of one or more carriers onto which a piece of material having piezoelectric properties is attached. Piezo-electric elements are understood to comprise also piezo-resistive and piezo-capacitive elements.

Such piezoelectric modules are generally known, examples being provided by EP 1 191 610, JP 2003 198313 and JP 09166616.

With such piezoelectric modules according to the prior art, the piezoelectric element is supported at its edges, whereby the activating means are arranged for exerting a force on the middle of the piezoelectric element. As a result thereof, the piezoelectric element is two-dimensionally deformed, leading to a mechanical load on the element each time it is operated.

The present invention attempts to prevent this disadvantage by creating such a piezoelectric module, whereby the positioning means comprise two elongated support elements extending substantially parallel to each other on a first side of the piezoelectric element, such support elements being positioned at a distance from the middle of the piezoelectric element and whereby the activating element comprises a projection that is moveable in the transverse direction of the piezoelectric element, such a projection engaging with the second side of the piezoelectric element between the support elements on the piezoelectric element.

As a result of these measures, deformation only occurs in one direction, so that the element is not subjected to such a heavy load and the life of the piezoelectric element is expected to increase.

These advantages are particularly apparent if the piezoelectric element is rectangular in shape. Circular piezoelectric elements are usually applied in the prior art. It should be noted that other shapes, such as a rectangle, are not excluded for application of the present invention. It should furthermore be noted that the support elements are preferably in the shape of a rectangular bar, so that the nature of the deformation is more strongly determined and any deformation is counteracted in more than one direction, although other shapes and that differently shaped support elements can also be applied, such as curved support elements. In other respects, the shape of the support element is also dependent on the shape of the piezoelectric element.

According to a first preferred embodiment the activating means are connected with the positioning means through a rigid connection and that the activating means are adapted to move the projection relative to the positioning means through deformation.

Preferably the activating means and the support elements are formed out of plastic, having suitable electrical insulating properties, which is relatively cheap and which can easily be moulded.

According to the prior art a piezoelectric module is composed of separate components. By means of the measure whereby the activating element and the support elements form part of the same component the number of components can be significantly reduced.

It is however also possible to mould the activating means and the support elements from separate parts and to connect these through a rigid connection.

The piezoelectric element must be fixed in the positioning means. If the distance between the support elements and the activating element in the direction transverse to the principal plane of the piezoelectric element is less than the thickness of the piezoelectric element, the piezoelectric element is subjected to a continuous deformation, thus generating a spring force that clamps the piezoelectric element between the elongated support elements and the activating means.

As an alternative to or in combination with the measures referred to above, the piezoelectric element can be fixed by providing the support elements with parts laterally retaining the piezoelectric element.

Although asymmetric configurations are by no means excluded, it is preferable for the support elements to be positioned symmetrically with respect to the protrusion.

The number of components used to produce such a piezoelectric module can be further reduced if the activating element is attached to a deformable operating plate or if the activating element forms part of the deformable operating plate, which in turn forms part of the component.

Another way of reducing the number of components from which the module can be obtained is if the operating plate forms part of the housing of the switch.

According to the prior art, the piezoelectric module is accommodated in a separate switch casing. This switch casing is then placed in an opening that is made in the wall of the appliance in which the switch is to be mounted or in an opening in the switchboard in which the switch is to be mounted. This requires assembling the switch, making the opening and then placing the completed switch in the opening and connecting the switch. These operations can be reduced if the switch module is placed in an appliance provided with a housing, whereby the operating plate and possibly the support elements form part of the housing of the appliance. This measure is particularly attractive for small household appliances, such as electric shavers, electric toothbrushes or food mixers. In this respect, a housing will indeed usually be produced using injection-molding technology. This technology makes it possible to incorporate an activating element and two elongated support elements in the casing with minimum adjustment to the form applied for this technology. A housing produced with this form can then be provided with a piezoelectric element without applying further measures, thus obtaining an integrated piezoelectric switch - obviously once the electrical connecting means have been affixed. It should be noted that the presence of the switch is not visible from the outside. Marking must therefore be applied. For the rest, the fact that the switch is not visible means that it can be integrated into the outside of the device.

The measures according to the invention can obviously be applied with simple piezoelectric elements. However, it is also possible to apply the measures according to the invention with multiple piezoelectric elements, for example in applications in which safety requirements are set with respect to the reliability of the emission of a signal. In this respect it is possible to use a double structure as described in non-prepublished Dutch patent application 2000026. This may be implemented in that the positioning means comprise more than two elongated support elements extending on the first side of the piezoelectric element, whereby the activating element comprises projections engaging with the second side of the piezoelectric element between each pair of support elements, and whereby the piezoelectric element comprises a piezoelectric crystal between each pair of support elements. A multiple configuration is thus achieved that can be used for obtaining a stronger signal. The piezoelectric elements are hereby preferably electrically connected in series, although a parallel connection is not excluded: The projections are hereby operated simultaneously, for example by attaching each one to a shared, movable carrier. Besides it is possible to use the signals from the separate piezo-electric elements separately or to use them to increase the redundance in applications wherein safety is of utmost importance.

According to yet another preferred embodiment the housing of the module has an opening in at least one sidewall thereof, leading to the space between the activating means and the supporting means. This simplifies the piezoelectric element and the electrical connection means substantially, lowering the production costs.

Although the measures according to the invention can very effectively be applied with piezoelectric switch modules, whereby the electrical connecting means are formed by carriers adhered to the piezoelectric element on either side, it is particularly attractive if the electrical connecting means comprise an electrically insulating flexible carrier extending through the opening.

Yet a further simplication is reached when the electrical insulating carrier comprises an electrically insulating foil which is provided with electrically conductive tracks on one side and which is folded around the piezoelectric element, whereby the electrically conductive tracks are in contact with the appropriate parts of the piezoelectric element.
It should be noted in this respect that the film can also be divided into two parts, with an electrically conductive track being mounted in each part. The advantage of this is a minimal possibility of bypass.

The film must obviously be fixed onto the piezoelectric element. An attractive possibility is offered by the measure whereby the film is sealed onto itself outside the piezoelectric element. Other connecting means can also be applied. This creates a 'pocket' of film as it were, in which the piezoelectric element can be placed. The overall structure thus created can then be placed between the positioning means and the activating means. The production method thus achieved is extremely efficient, so it is possible to produce the switch module at an extremely low cost price. Furthermore, as a result, the film is pushed onto the piezoelectric element by the support elements and the activating element. This creates an additional means of fixing. It is otherwise possible to implement the seal seam in the form of a small number of, such as three, loose pointed contact surfaces. It is however preferable if the seal seam is closed such that the piezoelectric element placed between the film parts is surrounded on two sides by a closed seam and on a third side by a fold. These measures can also be applied in the situation in which the film is divided into two pieces.

It is however also possible for the electrical connecting means to comprise spring contacts. The film therefore becomes unnecessary. These spring contacts ensure electrical contact between the support elements and the piezoelectric element.

According to a further preferred embodiment, the electrical connecting means comprise contacts incorporated in the positioning means. This embodiment is particularly but not exclusively important in the situation in which the distance between the support elements and the activating element in the direction transverse to the principal plane of the piezoelectric element is less than the thickness of the piezoelectric element. Indeed the piezoelectric element is then clamped in between the two fixed parts, whereby the clamping force can be used for obtaining good electrical contact. Furthermore, this embodiment can be combined with a modem form of injection-molding technology, whereby conductors are mounted in the material formed by injection molding. These conductors can then easily be brought in contact with the piezoelectric element without going through the medium of separate parts.

As stated above, the measures according to the invention make it possible to use the application in small household appliances. To be able to apply the invention not only with appliances powered by a battery but also with appliances powered by mains voltage, a further preferred embodiment provides for the measure whereby the switch is arranged for supplying a voltage of over 200V and whereby the distance between the inside of the operating plate and the piezoelectric element is greater than 8mm. In particular, it is possible to select the distance so that the applicable legislation is complied with.

Further features of the present invention will emerge from the accompanying drawings, in which the following are shown:
- Figure 1:: a schematic three-dimensional view of a first embodiment according to the present invention;
- Figure 2:: a cross-section view of the first embodiment in a more completed form;
- Figure 3:: a cross-section view of the first embodiment in a fully completed form;
- Figure 4:: a cross-section view of according to the line IV-IV in figure 3;
- Figure 5:: a cross-section view of a second embodiment; and
- Figure 6:: a cross-section view of a third embodiment.

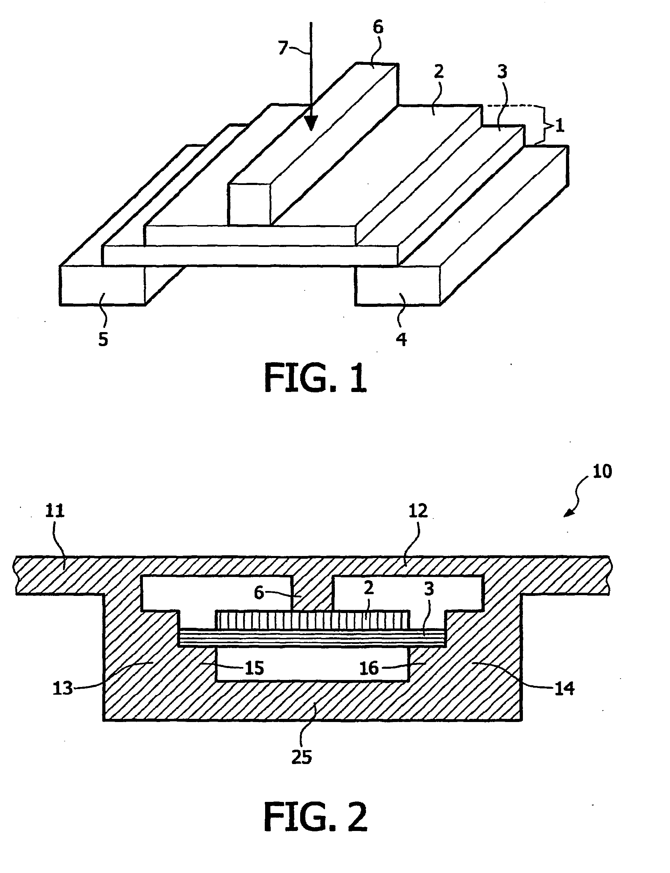

Figure 1 shows a piezoelectric element indicated in its entirety by the number 1, which is formed by a piezoelectric crystal 2 attached to a carrier 3. The opposite edges of the piezoelectric element rest on two elongated support elements 4, 5. The piezoelectric element is preferably rectangular, although other shapes are not excluded. An activating element in the form of a bar 6 extending parallel to the support elements 4, 5 rests on top of the piezoelectric crystal. The sizing is such that the piezoelectric element 1 is clamped in between the support elements and bar 6. When a force is exerted on the bar in the direction of arrow 7, the piezoelectric element and thus the piezoelectric crystal will be deformed in a single direction of curve.

As shown in Figure 2, this configuration is integrated into a suitably adjusted wall 11 of a casing 10, such as a switch casing or appliance casing. To this end, the wall 11 is provided with a thinner section 12, so that the wall 11 can be deformed at the location of the thinner section 12. The measurements of the deformable part of the wall can obviously be adjusted to the material and application; it is possible to vary both the thickness and dimensions in the plane of the wall. A graduated elongated ridge piece 13, 14 is affixed on both sides of the thinner section. The side edges of the carrier 3 of the piezoelectric element 1 rest on the shoulders 15, 16 obtained by means of the graduated form, said shoulders acting as support elements. The ridge pieces 13, 14 are connected on their underside by a closing sheet 25 that otherwise only acts as a means of protection and reinforcement. The bar 6 is affixed in the middle of the deformable part 12 of the wall. This bar 6 is used to transfer the displacement toward the piezoelectric element 1, caused by pushing in the deformable part 12. The wall 10, and the parts formed around it such as the bar 6, the ridge pieces 13, 14 and the closing sheet 25 are produced together by means of an injection-molding process.

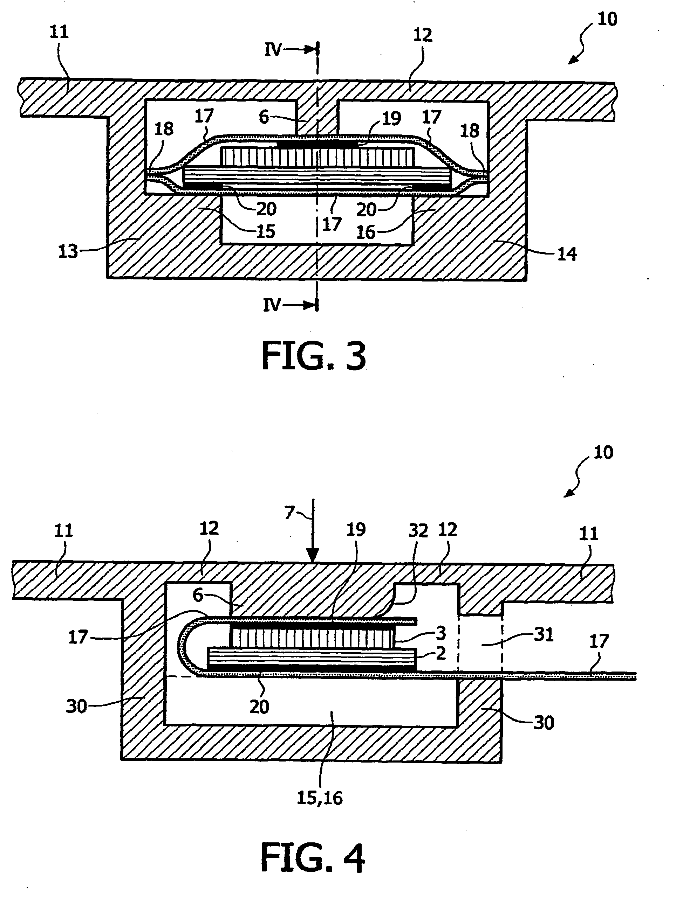

However, the components described above still have to be electrically connected. To this end, as shown in Figure 3, a film 17 is used, which extends in the longitudinal direction of the bar 6 and which is double-folded over at least the depth of the piezoelectric element 1. The side edges 18 of the double-folded part are connected to each other, for example by means of sealing or adhering. A sort of pocket is thus formed, in which the piezoelectric element is placed. The inside surface of the film 17 is provided with electrically conductive tracks 19, 20, the pattern of which is arranged to come into contact with the contacts mounted on the piezoelectric element. In this way, the electrical contacts and the tracks are positioned in such a way that the contacts 21 on the underside of the piezoelectric element 1 are pushed onto the shoulders and the electrical contact 21 present on the upper side is pushed by the bar onto the piezoelectric element. A configuration is thus obtained that can easily be assembled and requires few components, ensuring a low cost price. The film hereby extends in the direction transverse to the plane of the drawing. As appears from figure 4, a window 31 has been provided in one of the side walls 20 of the housing 10, through which the pre mounted unit of the piezoelectric element 2, the carrier 3 and the foil 17 with tracks 28, 29 thereon can be inserted to be mounted in its location. When the unit has been located, the foil 17 extends through the window.

Further it appears from figure 4 that the bar 6 comprises a chamfer 32 towards the side of the window 31. This chamfer 32 allows an easy insertion of the pre mounted unit of the piezoelectric element 2, the carrier 3 and the foil 17 with the tracks 28,29.

The film on which the tracks are mounted can be connected to the appropriate components by means of connectors, such as ZIF connectors, clamp or shrink contacts or soldering.
Otherwise, various changes can be made to the embodiment shown: the film can be connected via sealing or adhesive points instead of by sealing edges, and the contact pressure can be generated by appropriate components specifically applied for this purpose, such as springs.

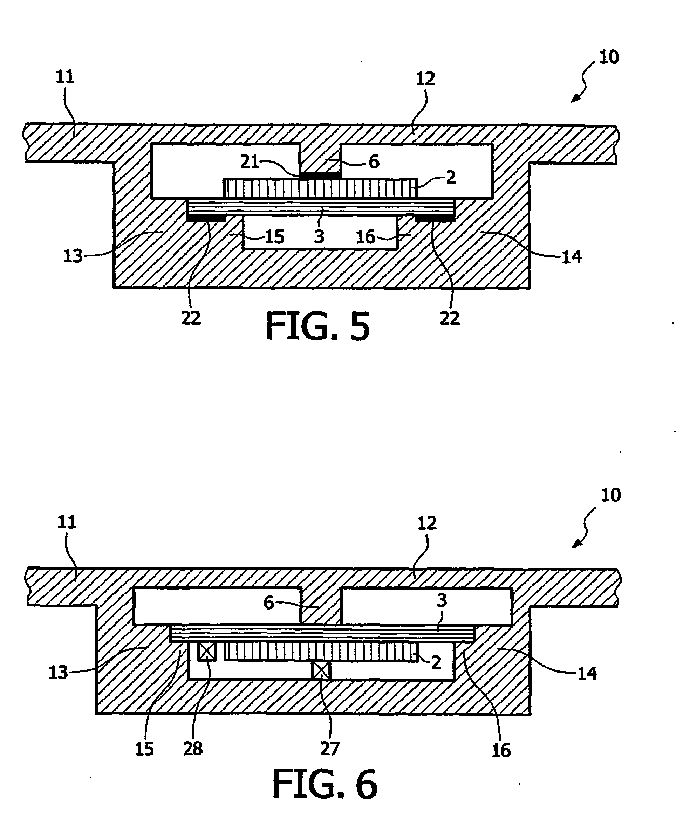

Figure 5 shows an embodiment, whereby the electrical connection is formed by conductors 21, 22 incorporated in the plastic of the wall, such conductors acting not only as a means of making electrical contact with the contacts of the piezoelectric element, but also as a conductor toward parts or contacts incorporated elsewhere in the casing. The technique of mounting conductors in injection-molded components is known. Here too, the sizing according to which the piezoelectric element is clamped between the bar and the shoulders is important for maintaining a good contact.

Finally, Figure 6 shows an embodiment, whereby contact springs are used for making contact between the piezoelectric element and the fixed structure of the casing. These springs can be connected to wires, films provided with conductors or ribbon cables, but they can also be connected to conductors incorporated in the plastic, as with the previous embodiment. The use of springs means that clamping force between the components of the casing and the piezoelectric element is not necessary for ensuring good electrical contact. This means that the piezoelectric element can therefore be fixed in a way other than via clamping force, for example via lateral form retention.

The embodiment shown can furthermore differ by the position of the piezoelectric element; it can be turned around with respect to the embodiment shown in the previous figures. It is otherwise also possible to apply piezoelectric elements using other configurations, such as two piezoelectric crystals, or other assemblies.

The configurations described above each relate to a simple configuration; it is possible to apply multiple configurations, for example by placing more than one of the configurations described above next to each other. The piezoelectric element is then provided with more than one piezoelectric crystal, albeit affixed on the same carrier.

When the - multiple - activating element is operated, the carrier is deformed in a wave shape.

## Claims

1. Piezoelectric module for a switch, comprising:
- a substantially flat piezoelectric element that is arranged for emitting an electrical signal on mechanical deformation;
- electrical connecting means for electrically connecting the piezoelectric element (2);
- positioning means (3) for positioning the piezoelectric element; and
- activating means (6) for deforming the piezoelectric element.
**characterized in that**
- the positioning means comprise two elongated support elements (4,5) extending substantially parallel to each other on a first side of the piezoelectric element (2) such support elements being equidistant from the middle of the piezoelectric element and **in that** the activating means (6) comprise at least one projection moveable in the transverse direction of the piezoelectric element (2), such a projection engaging with the second side of the piezoelectric element between the support elements (4,5) on the piezoelectric element (2).

2. Piezoelectric module according to claim 1, **characterized in that** the activating means are connected with the positioning means through a rigid connection and that the activating means (6) are adapted to move the projection relative to the positioning means (3) through deformation.

3. Piezoelectric module according to claim 1 or 2, **characterized in that** the activating means (6) and the support elements (4,5) are formed out of plastic.

4. Piezoelectric module according to claim 2 or 3, **characterized in that** the activating means (6) and the support elements (4,5) form part of the same component.

5. Piezoelectric module according to claim 2 or 3, **characterized in that** the activating means (6) and the supporting elements (4,5) are formed from separate parts and that the parts are connected through a rigid connection.

6. Piezoelectric module according to any of the preceding claims, **characterized in that** the distance between the support elements (4,5) and the projection in the direction transverse to the principal plane of the piezoelectric element (2) is less than the thickness of the piezoelectric element (2).

7. Piezoelectric module according to any one of the preceding claims, **characterized in that** the support elements (4,5) are provided with parts laterally retaining the piezoelectric element (2).

8. Piezoelectric module according to any one of the preceding claims, **characterized in that** the support elements (4,5) are symmetrically positioned with respect to the activating element (6).

9. Piezoelectric module according to claim 2, **characterized in that** the activating means comprise a deformable operating plate.

10. Piezoelectric module according to claim 9, **characterized in that** the operating plate forms part of the housing of the switch.

11. Piezoelectric module according to claim 10, **characterized in that** the switch is placed in an appliance provided with a housing and **in that** the operating plate forms part of the housing of the appliance.

12. Piezoelectric module according to claim 10 or 11, **characterized in that** the housing of the module has an opening in at least one sidewall thereof, leading to the space between the activating means (6) and the support elements (4,5).

13. Piezoelectric module according to claim 12, **characterized in that** the electrical connection means and the piezoelectric element (2) have been provided on a flexible carrier and that the carrier extends through the opening.

14. Piezoelectric module according to claim 13, **characterized in that** the electrical connecting means comprise an electrically insulating film, which is provided with electrically conductive tracks on one side and which is folded around the piezoelectric element (2), whereby the electrically conductive tracks are in contact with the appropriate parts of the piezoelectric element (2).

15. Piezoelectric module according to claim 13, **characterized in that** the film is sealed onto itself outside the piezoelectric element (2).

16. Piezoelectric module according to any one of the preceding claims, **characterized in that** the switch is arranged for supplying a voltage of over 200V and **in that** the distance between the inside of the operating plate and the piezoelectric element (2) is greater than 8 mm.

## Patentansprüche

1. Piezoelektrisches Modul für einen Schalter, das umfasst:
- ein im Wesentlichen flaches piezoelektrisches Element, das für die Aussendung eines elektrischen Signals aufgrund mechanischer Verformung angeordnet ist;
- elektrische Verbindungsmittel zur elektrischen Verbindung des piezoelektrischen Elements (2);
- Positionierungsmittel (3) zum Positionieren des piezoelektrischen Elements und
- Aktivierungsmittel (6) zum Verformen des piezoelektrischen Elements.
**dadurch gekennzeichnet, dass**
- die Positionierungsmittel zwei längliche Stützelemente (4, 5) umfassen, die sich im Wesentlichen parallel zueinander an einer ersten Seite des piezoelektrischen Elements (2) erstrecken, derart dass die Stützelemente von der Mitte des piezoelektrischen Elements gleich weit entfernt sind, und dass die Aktivierungsmittel (6) mindestens einen Vorsprung umfassen, der in der Querrichtung zum piezoelektrischen Element (2) beweglich ist, derart dass ein Vorsprung mit der zweiten Seite des piezoelektrischen Elements zwischen den Stützelementen (4, 5) auf dem piezoelektrischen Element (2) angreift.

2. Piezoelektrisches Modul nach Anspruch 1, **dadurch gekennzeichnet, dass** die Aktivierungsmittel (6) mit den Positionierungsmitteln über eine starre Verbindung verbunden sind und dass die Aktivierungsmittel (6) angepasst sind, den Vorsprung relativ zu den Positionierungsmitteln (3) aufgrund von Verformung zu bewegen.

3. Piezoelektrisches Modul nach Anspruch 1 oder 2**, dadurch gekennzeichnet, dass** die Aktivierungsmittel (6) und die Stützelemente (4, 5) aus Kunststoff gestaltet sind.

4. Piezoelektrisches Modul nach Anspruch 2 oder 3, **dadurch gekennzeichnet, dass** die Aktivierungsmittel (6) und die Stützelemente (4, 5) Teil desselben Bauelements bilden.

5. Piezoelektrisches Modul nach Anspruch 2 oder 3, **dadurch gekennzeichnet, dass** die Aktivierungsmittel (6) und die Stützelemente (4, 5) aus getrennten Teilen gebildet werden und dass die Teile über eine starre Verbindung miteinander verbunden sind.

6. Piezoelektrisches Modul nach einem der vorhergehenden Ansprüche, **dadurch gekennzeichnet, dass** der Abstand zwischen den Stützelementen (4, 5) und dem Vorsprung in der Richtung quer zur Hauptebene des piezoelektrischen Elements (2) geringer als die Dicke des piezoelektrischen Elements (2) ist.

7. Piezoelektrisches Modul nach einem der vorhergehenden Ansprüche, **dadurch gekennzeichnet, dass** die Stützelemente (4, 5) mit Teilen versehen sind, die das piezoelektrische Element (2) seitlich halten.

8. Piezoelektrisches Modul nach einem der vorhergehenden Ansprüche, **dadurch gekennzeichnet, dass** die Stützelemente (4, 5) bezogen auf das Aktivierungselement (6) symmetrisch angeordnet sind.

9. Piezoelektrisches Modul nach Anspruch 2, **dadurch gekennzeichnet, dass** die Aktivierungsmittel (6) eine verformbare Bedienungsplatte umfassen.

10. Piezoelektrisches Modul nach Anspruch 9, **dadurch gekennzeichnet, dass** die Bedienungsplatte Teil des Gehäuses des Schalters bildet.

11. Piezoelektrisches Modul nach Anspruch 10, **dadurch gekennzeichnet, dass** der Schalter sich in einem Gerät befindet, das mit einem Gehäuse ausgestattet ist und dass die Bedienungsplatte einen Teil des Gehäuses des Geräts bildet.

12. Piezoelektrisches Modul nach Anspruch 10 oder 11, **dadurch gekennzeichnet, dass** das Gehäuse des Moduls in mindestens einer Seitenwand eine Öffnung besitzt, die zu dem Raum zwischen den Aktivierungsmitteln (6) und den Stützelementen (4, 5) führt.

13. Piezoelektrisches Modul nach Anspruch 12, **dadurch gekennzeichnet, dass** die elektrischen Verbindungsmittel und das piezoelektrische Element (2) auf einem biegsamen Träger bereitgestellt werden und dass der Träger sich durch die Öffnung erstreckt.

14. Piezoelektrisches Modul nach Anspruch 13, **dadurch gekennzeichnet, dass** die elektrischen Verbindungsmittel einen elektrisch isolierenden Film umfassen, der mit elektrisch leitenden Bahnen an einer Seite ausgestattet ist und der um das piezoelektrische Element (2) gefaltet ist, wobei die elektrisch leitenden Bahnen mit den entsprechenden Teilen des piezoelektrischen Elements (2) in Kontakt stehen.

15. Piezoelektrisches Modul nach Anspruch 13, **dadurch gekennzeichnet, dass** der Film außerhalb des piezoelektrischen Elements (2) in sich selbst versiegelt ist.

16. Piezoelektrisches Modul nach einem der vorhergehenden Ansprüche, **dadurch gekennzeichnet, dass** der Schalter für eine Speisespannung von mehr als 200 V ausgelegt ist und dass der Abstand zwischen der Innenseite der Bedienungsplatte und dem piezoelektrischen Element (2) mehr als 8 mm beträgt.

## Revendications

1. Module piézo-électrique pour commutateur, comprenant :
- un élément piézo-électrique sensiblement plat qui est agencé pour émettre un signal électrique lors d'une déformation mécanique ;
- des moyens de connexion électrique pour connecter électriquement l'élément piézo-électrique (2) ;
- des moyens de positionnement (3) pour positionner l'élément piézo-électrique, et
- des moyens d'activation (6) pour déformer l'élément piézo-électrique,
**caractérisé en ce que**
- les moyens de positionnement comprennent deux éléments de support allongés (4, 5) s'étendant de manière sensiblement parallèle l'un à l'autre sur un premier côté de l'élément piézo-électrique (2), ces éléments de support étant équidistants du milieu de l'élément piézo-électrique, et **en ce que** les moyens d'activation (6) comprennent au moins une saillie déplaçable dans le sens transversal de l'élément piézo-électrique (2), une telle saillie prenant appui sur le second côté de l'élément piézo-électrique entre les éléments de support (4, 5) sur l'élément piézo-électrique (2).

2. Module piézo-électrique selon la revendication 1, **caractérisé en ce que** les moyens d'activation sont connectés aux moyens de positionnement par une connexion rigide et **en ce que** les moyens d'activation (6) sont adaptés pour déplacer la saillie relativement aux moyens de positionnement (3) par déformation.

3. Module piézo-électrique selon la revendication 1 ou 2, **caractérisé en ce que** les moyens d'activation (6) et les éléments de support (4, 5) sont faits en plastique.

4. Module piézo-électrique selon la revendication 2 ou 3, **caractérisé en ce que** les moyens d'activation (6) et les éléments de support (4, 5) font partie du même composant.

5. Module piézo-électrique selon la revendication 2 ou 3, **caractérisé en ce que** les moyens d'activation (6) et les éléments de support (4, 5) sont réalisés à partir de pièces distinctes et **en ce que** les pièces sont connectées au moyen d'une connexion rigide.

6. Module piézo-électrique selon l'une quelconque des revendications précédentes, **caractérisé en ce que** la distance entre les éléments de support (4, 5) et la saillie dans le sens transversal au plan principal de l'élément piézo-électrique (2) est inférieure à l'épaisseur de l'élément piézo-électrique (2).

7. Module piézo-électrique selon l'une quelconque des revendications précédentes, **caractérisé en ce que** les éléments de support (4, 5) sont pourvus de pièces retenant latéralement l'élément piézo-électrique (2).

8. Module piézo-électrique selon l'une quelconque des revendications précédentes, **caractérisé en ce que** les éléments de support (4, 5) sont positionnés symétriquement par rapport à l'élément d'activation (6).

9. Module piézo-électrique selon la revendication 2, **caractérisé en ce que** les moyens d'activation comprennent une plaque d'actionnement déformable.

10. Module piézo-électrique selon la revendication 9, **caractérisé en ce que** la plaque d'actionnement fait partie du logement du commutateur.

11. Module piézo-électrique selon la revendication 10, **caractérisé en ce que** le commutateur est placé dans un appareil pourvu d'un logement et **en ce que** la plaque d'actionnement fait partie du logement de l'appareil.

12. Module piézo-électrique selon la revendication 10 ou 11, **caractérisé en ce que** le logement du module comporte une ouverture dans au moins l'une de ses parois latérales, qui conduit à un espace entre les moyens d'activation (6) et les éléments de support (4, 5).

13. Module piézo-électrique selon la revendication 12, **caractérisé en ce que** les moyens de connexion électrique et l'élément piézo-électrique (2) ont été prévus sur un support flexible et **en ce que** le support s'étend à travers l'ouverture.

14. Module piézo-électrique selon la revendication 13, **caractérisé en ce que** les moyens de connexion électrique comprennent un film électriquement isolant qui est pourvu sur un côté de pistes conduisant l'électricité et qui est replié autour de l'élément piézo-électrique (2) de telle sorte que les pistes conduisant l'électricité soient en contact avec les parties appropriées de l'élément piézo-électrique (2).

15. Module piézo-électrique selon la revendication 13, **caractérisé en ce que** le film est scellé sur lui-même à l'extérieur de l'élément piézo-électrique (2).

16. Module piézo-électrique selon l'une quelconque des revendications précédentes, **caractérisé en ce que** le commutateur est agencé pour fournir une tension supérieure à 200 V et **en ce que** la distance entre l'intérieur de la plaque d'actionnement et l'élément piézo-électrique (2) est supérieure à 8 mm.
